# DEMANDE DE BREVET EUROPEEN

(11) **EP 1 312 927 A1**
(43) Date de publication de la demande: **21.05.2003**
(21) Numéro de dépôt: 02364040.2
(22) Date de dépôt: 14.11.2002
(51) Int. Cl.: G01R 19/165

(54) **Détecteur de surcharge pour un convertisseur de tension continue**

(30) Priorité: 19.11.2001 FR 0114963
(71) Demandeur: ATMEL NANTES SA, 44306 Nantes Cédex 3 (FR)
(72) Inventeur: Messager, Philippe, 44000 Nantes (FR)
(74) Mandataire: Vidon, Patrice

(57) **Abrégé**

L'invention concerne un détecteur de surcharge pour convertisseur de tension continue, ledit convertisseur délivrant un courant de charge ayant une tension de sortie (Vout) pouvant être différente d'une tension d'alimentation (Vbat), à l'aide d'une inductance (L) et d'un premier transistor (TP0) rendu passant ou bloqué par des moyens de régulation en fonction de la quantité de courant demandée par ladite charge, ledit détecteur comprenant des moyens d'obtention d'une image dudit courant de charge à une échelle inférieure prédéterminée et des moyens d'analyse tenant compte de ladite image du courant de charge pour délivrer une information de surcharge lorsque ladite quantité de courant est supérieure à un seuil de courant prédéterminé.

## Description

Le domaine de l'invention est celui de l'alimentation de circuits électroniques, et en particulier des convertisseurs DCDC (convertisseurs de tension continue), destinés à délivrer un courant de charge ayant une tension de sortie différente de la tension d'alimentation qu'ils reçoivent. Plus précisément, l'invention concerne la détection d'une éventuelle surcharge, afin d'éviter une détérioration du circuit alimenté.

L'invention trouve des applications dans de nombreux domaines, dès lors qu'il est nécessaire de modifier une tension et de contrôler un courant d'alimentation. Un exemple particulier d'application est celui de l'alimentation d'une carte à puce (carte SIM, carte bancaire,...) coopérant avec un radiotéléphone, délivrant une tension variable à partir de sa batterie.

On connaît plusieurs types de convertisseurs DCDC. Il existe notamment des convertisseurs à capacités commutées, qui offrent un rendement insuffisant, et des convertisseurs selfiques, auxquels s'applique plus particulièrement l'invention.

Le principe d'un convertisseur selfique est basé sur le fait qu'une inductance s'oppose aux variations de courant, en augmentant ou en diminuant la tension à ses bornes, selon la règle : dV/dt = L.di/dt.

Le but du convertisseur est d'augmenter (mode pompe) ou de diminuer (mode régulateur) une tension de sortie (Vout) par rapport à une tension d'alimentation (Vbat). Par exemple, dans le cas d'une carte à puce alimentée par un radiotéléphone, la tension de sortie devra valoir en permanence 5 V alors que la batterie pourra délivrer une tension comprise entre 2,7 et 5,5 V selon son état.

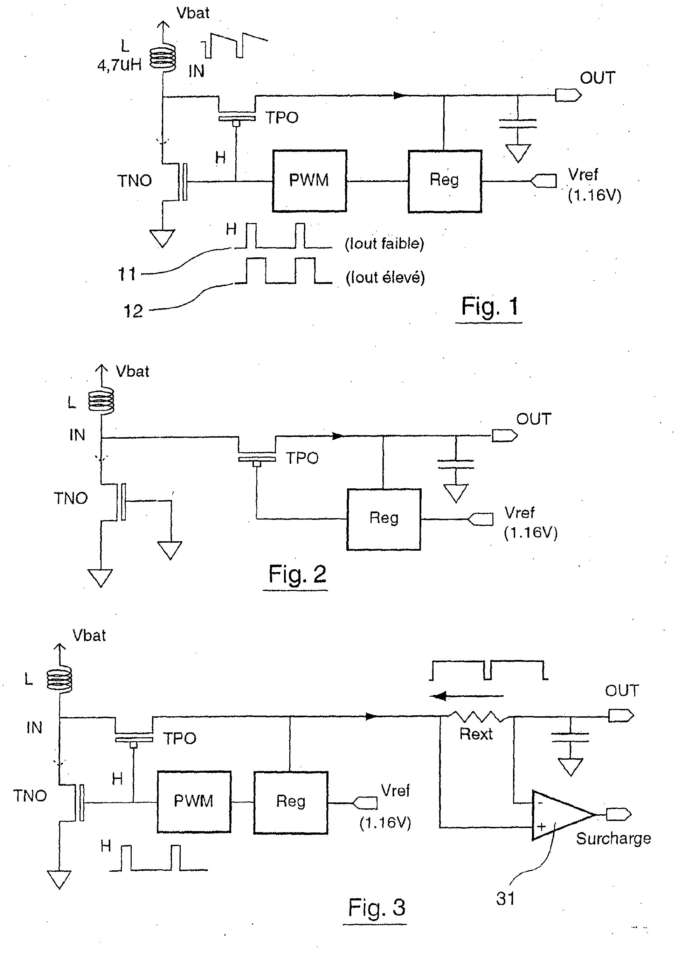

La figure 1 illustre le fonctionnement d'un convertisseur selfique en mode pompe, c'est-à-dire lorsque Vbat > Vout. Il comprend donc une inductance L, valant par exemple 4,7 µH, dont l'une des extrémités est reliée à la batterie (Vbat) et l'autre extrémité (IN) est reliée d'une part à un transistor NMOS TN0 et d'autre part à un transistor PMOS TP0.

Ce dernier délivre la tension de sortie régulée Vout, sur la sortie OUT. Des moyens de régulation délivrent une commande H, agissant sur les deux transistors TN0 et TP0. Le transistor TN0 est passant lorsque H = Vbat et bloqué lorsque H = 0 V, contrairement à TP0, qui est passant lorsque H = 0 V et bloqué lorsque H = Vbat. Ils sont donc complémentaires.

Ce montage permet d'imposer dans l'inductance L un courant pendant un temps t0, grâce au transistor TN0, puis de couper ce transistor TN0 et d'ouvrir TP0 pendant un temps t1. L'inductance L emmagasine l'énergie pendant le temps t0, et la restitue pendant le temps t1, en essayant de s'opposer aux variations du courant.

Ainsi, quelle que soit la tension sur la borne OUT, l'inductance L va augmenter la tension sur la borne IN jusqu'à pouvoir délivrer le courant que le transistor TN0 lui a imposé pendant le temps t0. Cette technique permet donc de générer une tension Vout supérieure à la tension de batterie Vbat, tout en délivrant du courant, et en pouvant donc servir d'alimentation.

En fonction du courant Iout demandé par la charge, il suffit d'augmenter le rapport cyclique t0/(t0+t1). La figure 1 illustre ainsi deux exemples de commande H, selon que Iout est faible (11) ou élevé (12). Plus le temps t0 est important, plus le courant à la fin de ce temps t0 sera important, et plus l'inductance L emmagasine de l'énergie. En conséquence, le courant délivré pendant le temps t1 est plus important.

Pour obtenir cette commande H, un régulateur REG compare la tension de sortie Vout à une référence Vref (par exemple Vref = 1,16V) et agit sur un modulateur de largeur d'impulsion PWM (en anglais "pulse width modulation") qui fait varier le rapport cyclique t0/(t0+t1). Si Vout est inférieure à la tension désirée, le rapport cyclique augmente. Inversement, si Vout est supérieure à la tension désirée, ce rapport cyclique diminue.

Un tel convertisseur présente un bon rendement, compris entre 75 % et 98 % (alors que le rendement d'un convertisseur à capacités commutées est inférieur à 50 %).

Par ailleurs, il permet de passer aisément du mode pompe (si Vbat < Vout désirée), discuté ci-dessus, au mode régulateur (si Vbat > Vout désirée). Ce dernier cas peut correspondre, par exemple, au cas d'un radiotéléphone dont la batterie bien chargée délivre 5,5 V, alors que Vout doit être 5 V.

La figure 2 illustre le fonctionnement en mode régulateur. On arrête alors le modulateur PWM dès que Vbat > Vout désirée, et on connecte la sortie du régulateur REG directement sur la grille du transistor TP0. On obtient alors une tension analogique, et non plus numérique, régulée linéairement.

Afin de ne pas détériorer les composants du circuit alimenté, notamment s'il y a un court-circuit en sortie, ou pour détecter une erreur, il est nécessaire par ailleurs de contrôler le courant Iout fourni à la charge. Par exemple, si cette dernière est une carte à puce dont la consommation maximum est de 60 mA, il faut interrompre l'alimentation si le courant dépasse un seuil, par exemple 100 mA. En effet, cela signifie qu'il y a alors un problème sur la carte à puce, ou une mauvaise insertion de cette carte, ou encore une tentative de fraude (insertion d'une plaque métallique par exemple). Dans ce cas, il faut donc arrêter le système, et décharger la tension de sortie à 0 V.

Pour cela, selon l'art antérieur, on met en oeuvre une conversion courant/tension, selon le principe illustré en figure 3. On insère en série avec le transistor TP0 (ou TN0) une résistance Rext faible, pour ne pas trop dégrader le rendement.Un amplificateur 31 est connecté aux deux bornes de cette résistance Rext, et délivre le signal de surcharge, quand le courant est supérieur au seuil fixé.

Il n'est pas possible d'utiliser une résistance implantée sur le silicium, qui peut avoir une variation de l'ordre de 1 à 3 (d'où un risque d'erreur de mesure du courant de plus ou moins 100 %). Il est donc nécessaire d'ajouter cette résistance à l'extérieur du circuit.

Cette technique présente de nombreux inconvénients, en termes de coût (les résistances faibles et précises sont coûteuses), de montage, d'encombrement,... L'implantation d'une résistance de moins de 1 Ω est peu aisée. La détection de 100 mA suppose la présence d'au moins 100 mV (100 mA x 1Ω = 100 mV), et donc une dissipation de puissance de 0,1 x 0,1 = 10 mW.

En outre, cette technique est peu précise : la mesure ne se fait que pendant le temps t1 (ou le temps t0, si la résistance Rext est en série avec le transistor TN0). Cette mesure est instantanée et non une mesure moyenne. En d'autres termes, elle ne détecte pas les variations du rapport cyclique.

Enfin, avec la possibilité de passer du mode pompe au mode régulateur, cette résistance Rext ne peut être montée qu'en série avec le transistor PMOS TP0. Cela impose d'ajouter une entrée/sortie supplémentaire au circuit pour cette résistance précise extérieure.

L'invention a notamment pour objectif de pallier ces inconvénients de l'art antérieur.

Plus précisément, un objectif de l'invention est de fournir un détecteur de surcharge pour convertisseur de tension continue, qui soit plus précis que les détecteurs connus.

Un autre objectif de l'invention est de fournir un tel détecteur de surcharge, qui délivre une valeur moyenne, ne tenant pas compte du rapport cyclique, dans le monde pompe.

L'invention a également pour objectif de fournir un tel détecteur de surcharge, ne nécessitant pas l'utilisation d'une résistance extérieure, ou de tout autre composant extérieur, et n'imposant donc pas de sortie supplémentaire.

En d'autres termes, un objectif de l'invention est de fournir un tel détecteur de surcharge, qui soit peu coûteux à mettre en oeuvre, et qui présente un encombrement réduit, tout en étant plus précis et plus efficace.

Ces objectifs, ainsi que d'autres qui apparaîtront par la suite, sont atteints à l'aide d'un détecteur de surcharge pour convertisseur de tension continue, ledit convertisseur délivrant un courant de charge ayant une tension de sortie (Vout) pouvant être différente d'une tension d'alimentation (Vbat), à l'aide d'une inductance (L) et d'un premier transistor (TP0) rendu passant ou bloqué par des moyens de régulation en fonction de la quantité de courant demandée par ladite charge.

Selon l'invention, le détecteur de surcharge comprend des moyens d'obtention d'une image dudit courant de charge à une échelle inférieure prédéterminée et des moyens d'analyse tenant compte de ladite image du courant de charge pour délivrer une information de surcharge lorsque ladite quantité de courant est supérieure à un seuil de courant prédéterminé.

Ainsi, on dispose de façon simple et efficace d'une image du courant de charge précise, sans élément extérieur (tel qu'une résistance) et avec une faible dissipation de puissance.

De façon avantageuse, lesdits moyens d'analyse comprennent un comparateur comparant ladite tension de sortie (Vout) et la tension de ladite image du courant de charge, ledit comparateur délivrant une commande de remise à zéro quand ladite tension de l'image du courant de charge est supérieure à ladite tension de sortie.

Selon un mode de réalisation préférentiel de l'invention, lesdits moyens d'obtention d'une image du courant de charge comprennent donc un deuxième transistor (TP1) monté en miroir de courant par rapport à ce premier transistor (TP0), la largeur dudit deuxième transistor étant inférieure à la largeur dudit premier transistor dans une proportion correspondant à ladite échelle.

Selon un mode de réalisation particulier, ladite échelle vaut 1/1000.

Avantageusement, lesdits moyens d'obtention d'une image dudit courant de charge sont connectés à une source de courant contrôlée produisant un courant de référence proportionnel audit seuil de courant prédéterminé, à ladite échelle prédéterminée.

Un tel montage est en effet particulièrement simple, par rapport aux techniques antérieures.

Ainsi, préférentiellement :
- les drains desdits premier et deuxième transistors sont connectés à ladite inductance ;
- les grilles desdits premier et deuxième transistors sont connectés auxdits moyens de régulation.

De façon avantageuse, par ailleurs, lesdits moyens de régulation comprennent un régulateur tenant compte de ladite tension de sortie et contrôlant soit un modulateur de largeur d'impulsion (en mode pompe), soit directement les grilles desdits premier (TP0) et deuxième (TP1) transistors (en mode régulation).

L'invention concerne également les composants électroniques et les dispositifs comprenant au moins un détecteur de surcharge tel que décrit ci-dessus.

Avantageusement, un tel dispositif délivre une tension d'alimentation de sortie (Vout) destinée à alimenter au moins un élément périphérique susceptible de coopérer avec ledit dispositif, et notamment au moins une carte à micro-circuit.

Un tel dispositif peut par exemple être un radio-téléphone, ou comprendre des moyens de radio-téléphonie.

D'autres caractéristiques et avantages de l'invention apparaîtront plus clairement à la lecture de la description suivante d'un mode de réalisation préférentiel de l'invention, donné à titre de simple exemple illustratif et non limitatif, et des dessins annexés parmi lesquels
- les figures 1 et 2, déjà discutées en préambule, présentent les principes de fonctionnement, connus en eux-mêmes, d'un convertisseur DCDC selfique, respectivement en mode pompe et en mode régulateur ;
- la figure 3, également discutée en préambule, illustre un détecteur de surcharge à base de résistance extérieure, selon l'art antérieur, pour le convertisseur des figures 1 et 2 ;
- la figure 4 illustre un mode de réalisation d'un convertisseur à détecteur de surcharge interne selon l'invention ;
- la figure 5 est un schéma équivalent du dispositif de la figure 4 ;
- la figure 6 présente un exemple de réalisation d'une source de courant stable, pour le dispositif de la figure 4 ;
- les figures 7A à 7C illustrent une simulation du fonctionnement en mode pompe du dispositif de la figure 4 ;
- les figures 8 à 10 sont des portions agrandies de la simulation des figures 7A à 7C ;
- les figure 11A à 11D illustrent une simulation de fonctionnement en mode régulateur de dispositif de la figure 4.

Comme déjà mentionné, l'invention fournit donc un détecteur de surcharge, qui permet de détecter précisément le courant de sortie du convertisseur, sans élément externe et avec une très faible perte de rendement.

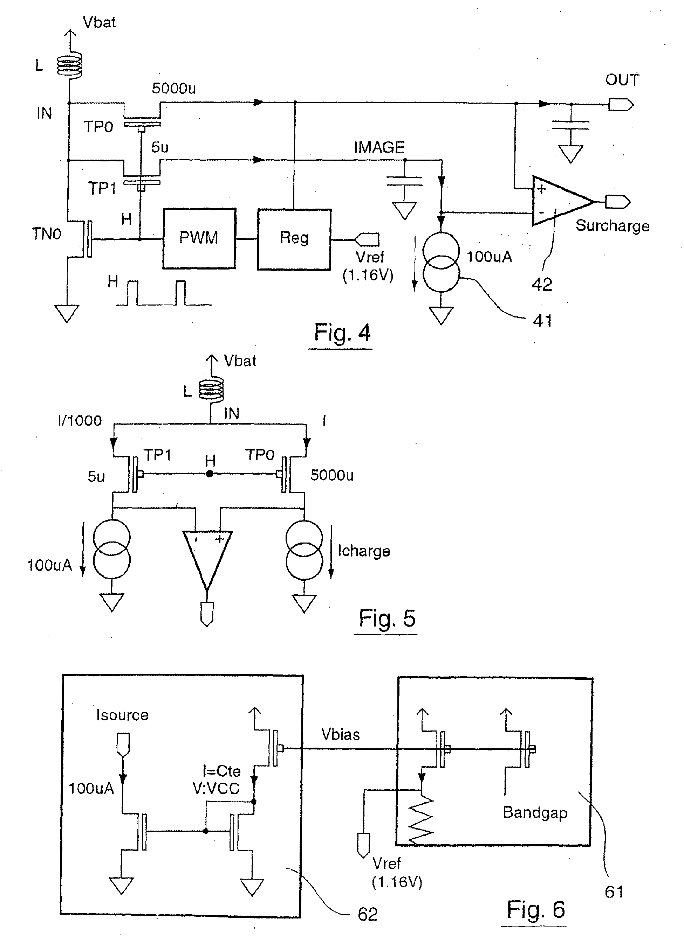

La figure 4 illustre un mode de réalisation préférentiel. On y retrouve, selon la même approche, certains éléments déjà commentés, et correspondant au principe de la figure 1. En revanche, on note que la résistance de la figure 2 a disparu.

Selon l'invention, on prévoit en outre un transistor TP1 monté en miroir de courant par rapport au transistor TP0. Ainsi, la grille du transistor TP1 est connectée à celle du transistor TP0, et le drain du transistor TP1 est connecté au drain du transistor TP0.

La taille du transistor TP1 est très inférieure à celle du transistor TP0. On considère par la suite à titre d'exemple qu'elle est 1000 fois inférieure, TP0 ayant une largeur de 5000 µ et TP1 une largeur de 5 µ. En conséquence, le transistor TP1 est une image du transistor TP0, à l'échelle 1/1000.

Une source de courant contrôlée 41, dont un exemple est décrit rapidement par la suite à titre indicatif, est connectée sur la source du transistor TP1 (appelée IMAGE). Le courant pompé par cette source de courant 41 est, dans l'exemple, de 100 µA.

Un comparateur 42 compare les tensions OUT (source de TP0) et IMAGE (source de TP1). Lorsque la tension IMAGE est supérieure à la tension OUT, cela signifie que le transistor TP1 délivre plus de courant que la source de courant 41 ne peut en tirer, soit plus de 100 µA.TP1 étant le miroir de TP0 à l'échelle 1/1000, on en déduit que le transistor TP0 délivre plus de 100 mA (1000 x 100 µA).

Cela veut dire que le système de régulation pompe trop, pour essayer de tenir la valeur de consigne désirée de la sortie OUT. On est donc en surcharge, la charge consommant plus de 100 mA.

Le comparateur 42 délivre l'information SURCHARGE, qui commande l'interruption de l'alimentation.

La figure 5 est un schéma équivalent (partiellement) à celui de la figure 4, permettant de mieux comprendre le principe de l'invention. L'inductance 1 est reliée via la borne IN aux deux transistors TP0 et TP1, montés en miroir de courant. Le transistor TP1 délivre du courant à une source de courant stable 41, alors que le transistor TP0 alimente la charge (Icharge).

Le comparateur 42 reçoit les tensions délivrées par chacun des transistors TP0 et TP1, et fournit l'information de surcharge (SURCHARGE = 0 V) dès que Icharge est supérieur à 100 mA.

On connaît différents types de source de courant stable. Un exemple de réalisation est illustré en figure 6. Il repose sur la mise en oeuvre d'un module "bandgap" 61, qui permet de disposer d'une référence de tension précise Vréf.

Pour délivrer cette tension précise, le module "bandgap" 61 délivre un courant précis dans une résistance et un transistor bipolaire. Ce courant est constant quelles que soient la température, la tension et le procédé de fabrication. Il suffit donc de le recopier (module 62), pour obtenir une source de courant Isource précise.

On présente maintenant plus en détail le fonctionnement du régulateur de l'invention, à partir de simulation.

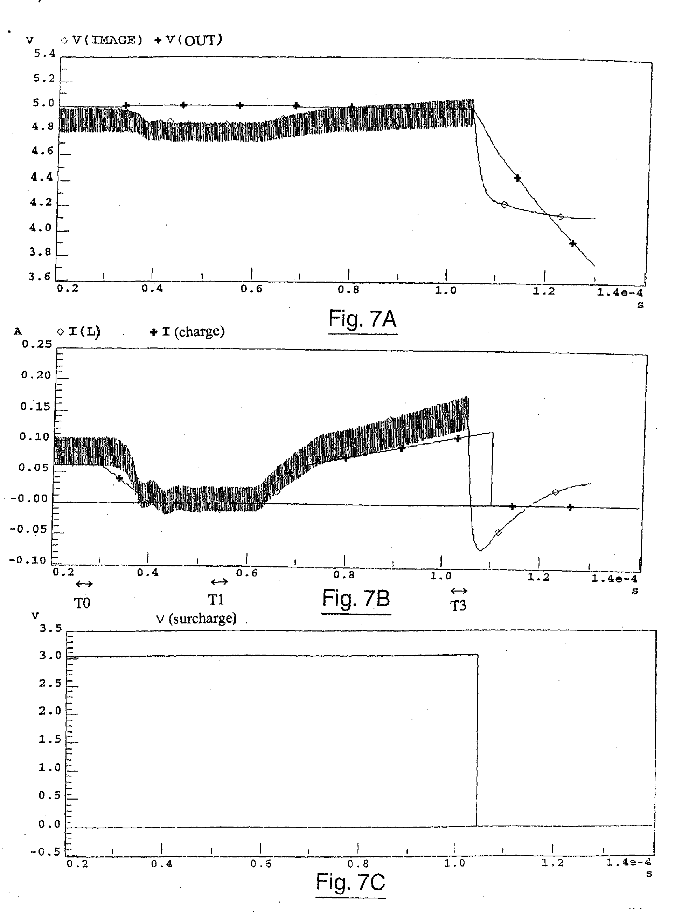

Les figures 7A à 7C illustrent un fonctionnement en mode pompe, avec respectivement :
- figure 7A : V(IMAGE) et V(OUT) ;
- figure 7B : I(L) et I(charge) ;
- figure 7C : V(surcharge).

On peut noter que l'on obtient bien une tension de sortie V(out) régulée à 5 V, jusqu'à l'instant où V(IMAGE) dépasse (en moyenne) V(out). Dès cet instant, V(surcharge) passe à zéro. Cet instant correspond bien à celui où le courant I(charge) a dépassé 100mA.

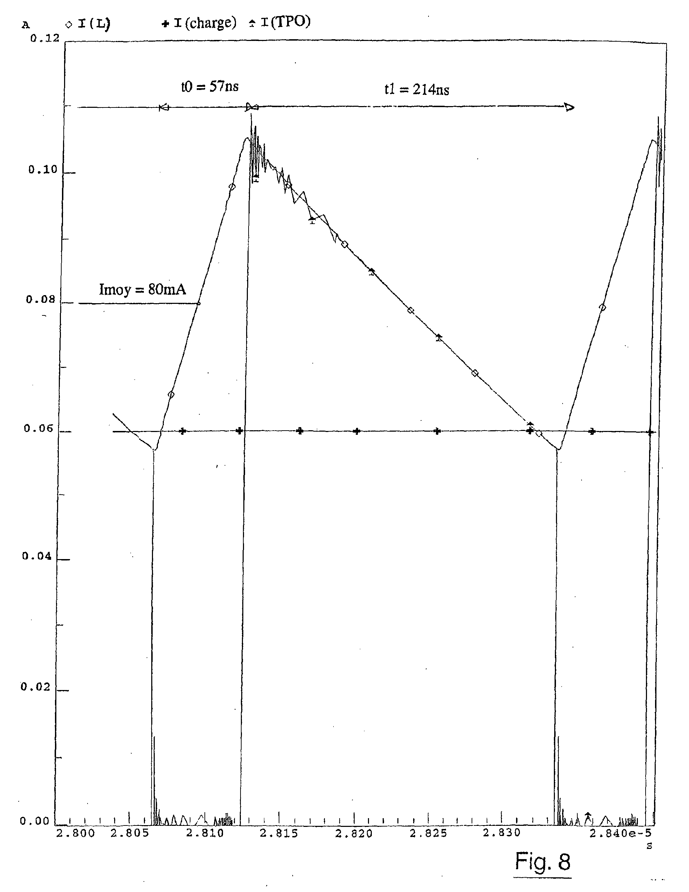

La figure 8 est une portion agrandie de la simulation des figures 7A à 7C, correspondant à la période T0. Elle illustre le fonctionnement du régulateur dans le cas où Icharge = 60 mA. On a alors t0 = 57 ns et t1 = 214 ns, et ρ = t0/(t0+t1) = 21 %, pour un courant moyen délivré par l'inductance de 80mA. On a également représenté le courant dans le transistor TP0, qui fonctionne selon le principe rappelé en préambule.

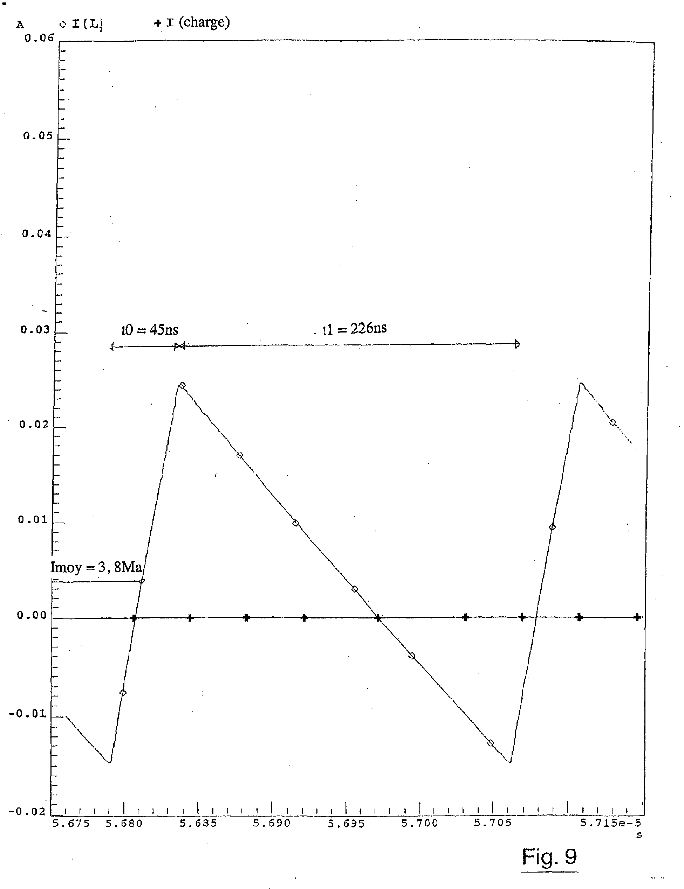

La figure 9 est une autre portion agrandie, correspondant à la période T1, dans laquelle le courant de charge est temporairement nul. Le rapport cyclique est alors modifié : ρ = 16,6 %, avec t0 = 45 ns et t1 = 226 ns.

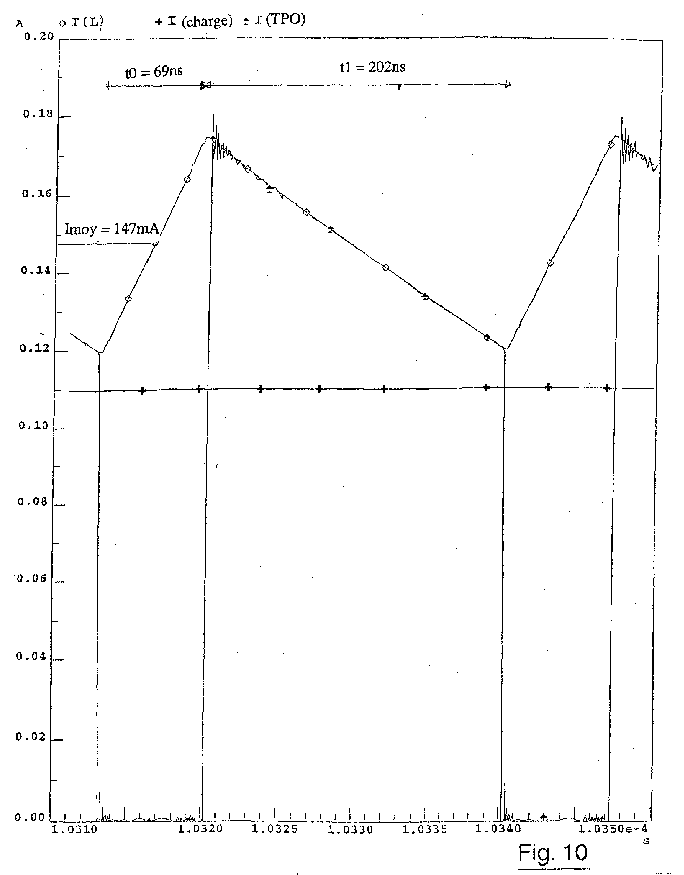

La figure 10 est encore une autre portion agrandie, correspondant à la période T2, dans laquelle le courant de charge augmente jusqu'à 110 mA. Le rapport cyclique est alors ρ = 25,5%, avec t0 = 69 ns et t1 = 202 ns, avant que le fonctionnement soit interrompu par V(surcharge).

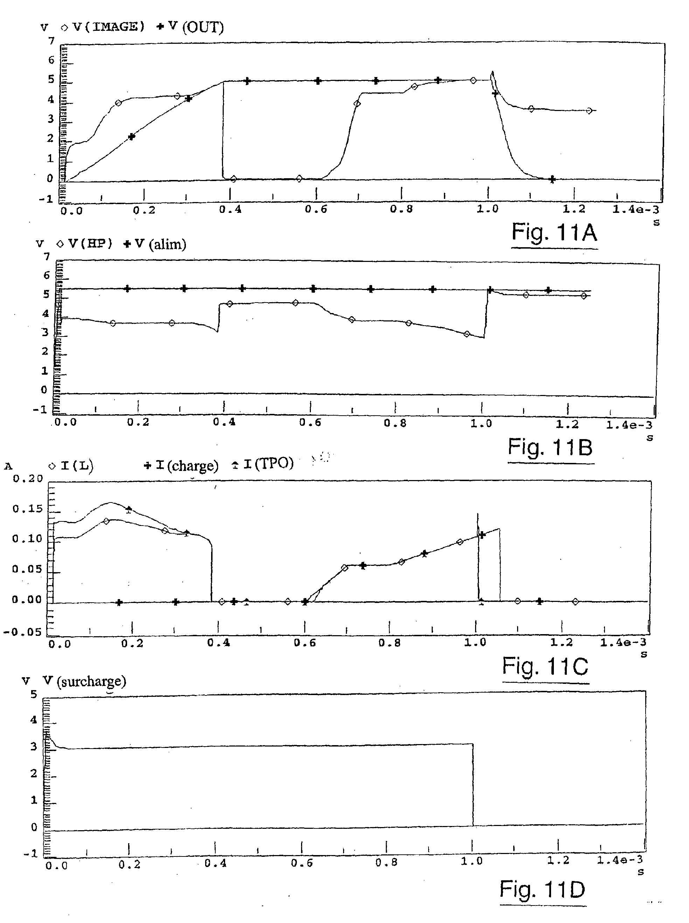

Les figures 11A à 11D illustrent le fonctionnement de l'invention en mode régulateur, avec :
- figure 11A : V(IMAGE) et V(OUT) ;
- figure 11B : V(HP) et V(alim) = 5,5 V (> 5 V) ;
- figure 11C : I(L), I(charge) et I(TP0) ;
- figure 11D : V(surcharge).

De la même façon que précédemment, on note que dès que V(IMAGE) dépasse V(OUT) (figure 11A), V(surcharge) passe à 0 V. En effet, I(charge) dépassait alors 100 mA (figure 11C).

On dispose ainsi, selon l'invention, d'un système fiable et efficace, n'utilisant pas de composant externe ni de sortie supplémentaire. Ce système est précis, grâce à la mise en oeuvre de la source de courant, et utilise au maximum 500 µW (100 µA x 5 V), alors que la technique, antérieure, consomme 10 mW pour un contrôle beaucoup moins précis.

En outre, la valeur de courant détectée est une valeur moyenne, et n'a pas à tenir compte du rapport cyclique, dans le mode pompe.

L'invention peut trouver de nombreuses applications dans de nombreux domaines, dès lors qu'il est nécessaire de disposer d'un convertisseur devant augmenter ou baisser la tension, et contrôler le courant. Elle peut en particulier s'appliquer aux systèmes mettant en oeuvre des cartes à puce (lecture de cartes bancaires ou de cartes SIM, dans un radiotéléphone, par exemple). Un autre exemple indicatif de mise est l'alimentation d'un microphone connecté à un téléphone.

## Revendications

1. Détecteur de surcharge pour convertisseur de tension continue, ledit convertisseur délivrant un courant de charge ayant une tension de sortie (Vout) pouvant être différente d'une tension d'alimentation (Vbat), à l'aide d'une inductance (L) et d'un premier transistor (TP0) rendu passant ou bloqué par des moyens de régulation en fonction de la quantité de courant demandée par ladite charge,
**caractérisé en ce qu'**il comprend des moyens d'obtention d'une image dudit courant de charge à une échelle inférieure prédéterminée et des moyens d'analyse tenant compte de ladite image du courant de charge pour délivrer une information de surcharge lorsque ladite quantité de courant est supérieure à un seuil de courant prédéterminé.

2. Détecteur de surcharge selon la revendication 1, **caractérisé en ce que** lesdits moyens d'analyse comprennent un comparateur comparant ladite tension de sortie (Vout) et la tension de ladite image du courant de charge,
ledit comparateur délivrant une commande de remise à zéro quand ladite tension de l'image du courant de charge est supérieure à ladite tension de sortie.

3. Détecteur de surcharge selon l'une quelconque des revendications 1 et 2, **caractérisé en ce que** lesdits moyens d'obtention d'une image du courant de charge comprennent un deuxième transistor (TP1) monté en miroir de courant par rapport à ce premier transistor (TP0), la largeur dudit deuxième transistor étant inférieure à la largeur dudit premier transistor dans une proportion correspondant à ladite échelle.

4. Détecteur de surcharge selon la revendication 3, **caractérisé en ce que** lesdits moyens d'obtention d'une image dudit courant de charge sont connectés à une source de courant contrôlée produisant un courant de référence proportionnel audit seuil de courant prédéterminé, à ladite échelle prédéterminée.

5. Détecteur de surcharge selon l'une quelconque des revendications 3 et 4, **caractérisé en ce que** :
- les drains desdits premier et deuxième transistors sont connectés à ladite inductance ;
- les grilles desdits premier et deuxième transistors sont connectés auxdits moyens de régulation.

6. Détecteur de surcharge selon l'une quelconque des revendications 1 à 5, **caractérisé en ce que** lesdits moyens de régulation comprennent un régulateur tenant compte de ladite tension de sortie et contrôlant soit un modulateur de largeur d'impulsion, en mode pompe, soit directement les grilles desdits premier (TP0) et deuxième (TP1) transistors, en mode régulation.

7. Détecteur de surcharge selon l'une quelconque des revendications 1 à 6, **caractérisé en ce que** ladite échelle vaut 1/1000.

8. Composant électronique **caractérisé en ce qu'**il comprend au moins un détecteur de surcharge selon l'une quelconque des revendications 1 à 7.

9. Dispositif **caractérisé en ce qu'**il comprend au moins un détecteur de surcharge selon l'une quelconque des revendications 1 à 7.

10. Dispositif selon la revendication 9, **caractérisé en ce que** ladite tension d'alimentation de sortie (Vout) est destinée à alimenter au moins un élément périphérique susceptible de coopérer avec ledit dispositif.

11. Dispositif selon la revendication 10, **caractérisé en ce qu'**au moins un desdits élément périphérique est une carte à micro-circuit.

12. Dispositif selon l'une quelconque des revendications 9 à 11, **caractérisé en ce qu'**il comprend des moyens de radio-téléphonie.
